# EUROPEAN PATENT APPLICATION

(11) **EP 4 322 207 A1**
(43) Date of publication of application: **14.02.2024**
(21) Application number: 22784340.6
(22) Date of filing: 15.02.2022
(51) Int. Cl.: H01L 23/28, H01L 23/473, H01L 25/07, H01L 25/18

(54) **POWER MODULE, AND METHOD FOR MANUFACTURING POWER MODULE**

(30) Priority: 06.04.2021 JP 2021064919
(71) Applicant: Mitsubishi Heavy Industries, Ltd., Tokyo 100-8332 (JP)
(72) Inventor: EZUMI, Masahiko, Tokyo 100-8332 (JP)
(74) Representative: Studio Torta S.p.A.
(86) International application number: PCT/JP2022/005897
(87) International publication number: WO 2022/215355

(57) **Abstract**

A power module includes: a circuit board on which a power semiconductor element is mounted; a base plate to which the circuit board is fixed; a terminal block including a base end surface which is fixed to an outer surface of the circuit board opposite to the base plate, a tip surface to which an external conductor having an electrical connection with an external object is able to be fixed, and an intermediate portion extending in a direction moving away from a front surface of the circuit board and electrically connecting the base end surface and the tip surface; and a reinforcement portion which is fixed to at least one of the circuit board and the base plate and which is formed to reinforce the terminal block, wherein the intermediate portion of the terminal block includes a receiving surface facing the tip surface side, and wherein the reinforcement portion includes a restriction surface which is formed to face the receiving surface in an extending direction of the intermediate portion to restrict displacement of the terminal block in a direction moving away from the front surface of the circuit board.

## Description

### Technical Field

The present disclosure relates to a power module and a method for manufacturing the power module.

Priority is claimed on Japanese Patent Application No. 2021-064919, filed April 6, 2021, the content of which is incorporated herein by reference.

### Background Art

Patent Document 1 discloses, for example, a power semiconductor module (hereinafter, referred to as a power module) used in a power conversion device such as an inverter.

### Citation List

### Patent Document(s)

Patent Document 1 Japanese Unexamined Patent Application No. 2019-71502

### Summary of Invention

### Technical Problem

Incidentally, further miniaturization is desired in order to improve an added value in the power module described in Patent Document 1.

However, loads caused when fastening conductors or loads caused by disturbance such as vibration may be added to input terminals and output terminals of the power module described in Patent Document 1. Therefore, since it is necessary to have sufficient strength to withstand these loads, it difficult to achieve further miniaturization without reducing the reliability of the terminals.

The present disclosure has been made in view of the above-described circumstances and an object thereof is to provide a power module that can be miniaturized without reducing the reliability of terminals and a method for manufacturing the power module.

### Solution to Problem

In order to solve the above-described problems, a power module according to the present disclosure is a power module for converting and outputting input power including: a circuit board on which a power semiconductor element is mounted; a base plate to which the circuit board is fixed; a terminal block including a base end surface which is fixed to an outer surface of the circuit board opposite to the base plate, a tip surface to which an external conductor having an electrical connection with an external object is allowed to be fixed, and an intermediate portion extending in a direction moving away from a front surface of the circuit board and electrically connecting the base end surface and the tip surface; and a reinforcement portion which is fixed to at least one of the circuit board and the base plate and which is formed to reinforce the terminal block, wherein the intermediate portion of the terminal block includes a receiving surface facing the tip surface side, and wherein the reinforcement portion includes a restriction surface which is formed to face the receiving surface in an extending direction of the intermediate portion and to restrict displacement of the terminal block in a direction moving away from the front surface of the circuit board.

Further, a method for manufacturing a power module according to the present disclosure includes: a terminal block molding step of molding a terminal block including a base end surface which is allowed to be fixed to a circuit board, a tip surface to which an external conductor electrically connected to an outside is allowed to be fixed, and an intermediate portion which electrically connects the base end surface and the tip surface and is provided with a recessed portion provided on a receiving surface facing the tip surface side; and a reinforcement portion molding step of molding a reinforcement portion by supplying a liquid synthetic resin into the recessed portion to cover the intermediate portion of the terminal block, and curing the synthetic resin in the recessed portion.

### Advantageous Effects of Invention

According to the present disclosure, it is possible to provide a power module that can be miniaturized without reducing the reliability of terminals and a method for manufacturing the power module.

### Brief Description of Drawings

FIG. 1 is a perspective view of a power module according to a first embodiment of the present disclosure and shows a state in which a reinforcement portion is removed.
FIG. 2 is a main enlarged perspective view of FIG. 1.
FIG. 3 is a perspective view of the power module according to the first embodiment of the present disclosure and shows a state in which the reinforcement portion is provided.
FIG. 4 is a cross-sectional view taken along a line IV-IV of FIG. 3.
FIG. 5 is a flowchart of a method for manufacturing the power module according to the first embodiment of the present disclosure.
FIG. 6 is a perspective view of a power module according to a second embodiment of the present disclosure.
FIG. 7 is a flowchart of a method for manufacturing the power module according to the second embodiment of the present disclosure.
FIG. 8 is a diagram showing a modified example of a terminal block of the power module according to the embodiment of the present disclosure.

### Description of Embodiments

### First Embodiment

### (Power module)

Hereinafter, a power module and a method for manufacturing the power module according to a first embodiment of the present disclosure will be described with reference to the drawings.

The power module of this embodiment constitutes a part of a power converter such as an inverter or a converter that converts and outputs input power. In this embodiment, a case in which the power module constitutes a part of an inverter having an input of direct current and an output of alternating current will be described as an example.

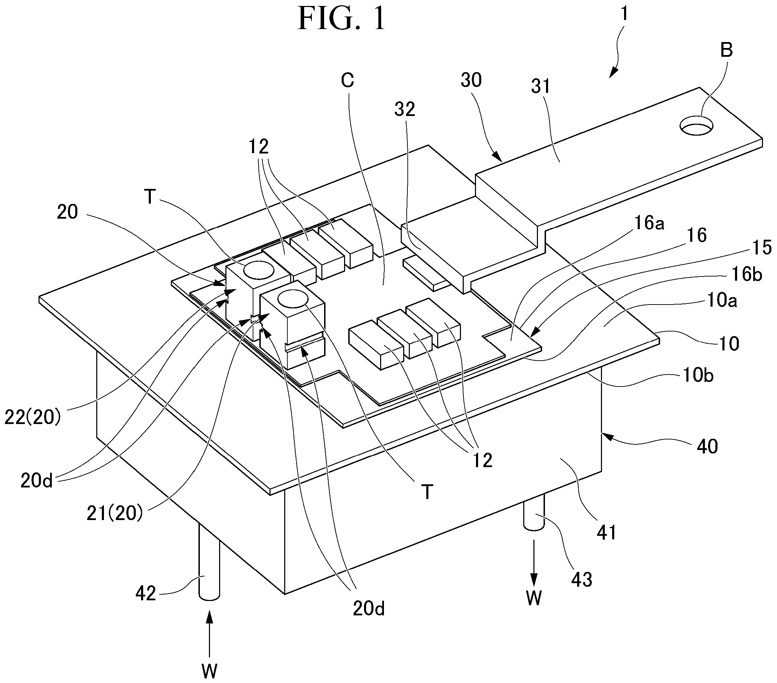

FIG. 1 is a perspective view of a power module according to this embodiment and shows a state in which a reinforcement portion is removed.

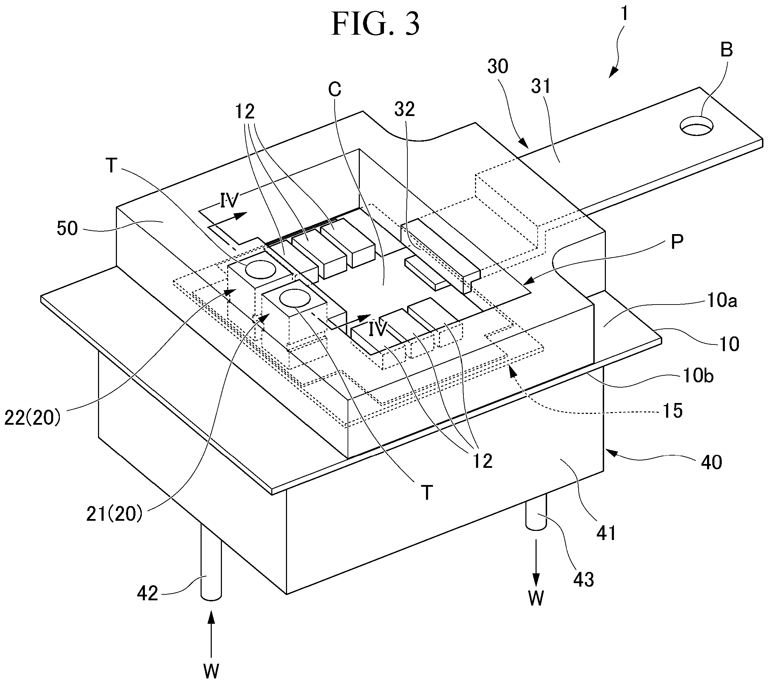

As shown in FIG. 1, a power module 1 of this embodiment includes a base plate 10, a circuit board 15, a terminal block 20, a power semiconductor element 12, a cooler 40, an output conductor 30, and a reinforcement portion 50 (see FIG. 3).

### (Base plate)

The base plate 10 is a plate-shaped member. The base plate 10 includes a first surface 10a and a second surface 10b which is located on the rear side of the first surface 10a. That is, the first surface 10a and the second surface 10b of the base plate 10 are back to back. In this embodiment, for example, copper is adopted in the base plate 10. Additionally, metals other than copper may be adopted in the base plate 10.

### (Circuit board)

The circuit board 15 includes a circuit board body 16 and a circuit pattern C.

The circuit board body 16 has a flat plate shape. This circuit board body 16 includes a front surface 16a and a rear surface 16b which is located on the rear side of the front surface 16a. The rear surface 16b of the circuit board body 16 is fixed to the first surface 10a of the base plate 10 via a bonding material or the like. The circuit board body 16 is formed of, for example, an insulating material such as ceramic. Additionally, as an insulating material for forming the circuit board body 16, paper phenol, paper epoxy, glass composite, glass epoxy, glass polyimide, fluororesin, and the like can be used in addition to the above ceramic.

The circuit pattern C is a pattern of copper foil or the like formed in the front surface 16a of the circuit board body 16. More specifically, the circuit pattern C is formed by etching or the like after being fixed to the front surface 16a of the circuit board body 16 by adhering or the like. The circuit pattern C of this embodiment is provided with an input circuit (not shown), an output circuit (not shown), and a control circuit (not shown). The input circuit (not shown) is a circuit pattern for inputting a current, input from the terminal block 20 to be described later, to the power semiconductor element 12 to be described later. The output circuit (not shown) is a circuit pattern for outputting a current converted by the power semiconductor element 12. The control circuit (not shown) is a circuit pattern connected to a control unit (not shown) that generates a control signal for controlling the behavior of the power semiconductor element 12.

### (Terminal block)

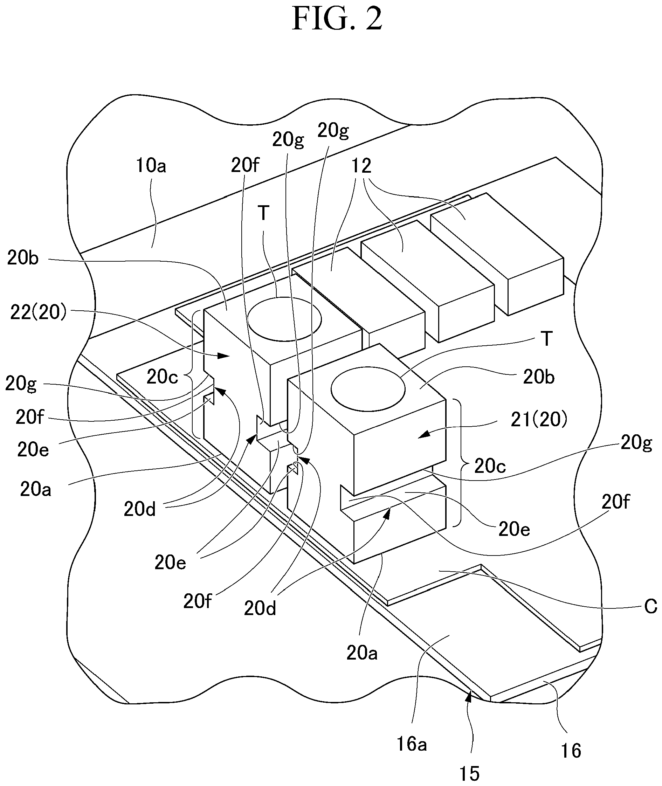

The terminal block 20 receives a current input from a current supply source (not shown) provided outside the power module 1 via a capacitor or the like (not shown). As shown in FIGS. 1 and 2, the terminal block 20 is formed of metal such as copper and is fixed to the circuit pattern C formed in the front surface 16a of the circuit board body 16. The terminal block 20 includes a base end surface 20a, a tip surface 20b, and an intermediate portion 20c.

The base end surface 20a is fixed to the surface facing the side opposite to the base plate 10 in the outer surface of the circuit board 15. More specifically, the base end surface 20a is in contact with the input circuit of the circuit pattern C formed in the front surface 16a of the circuit board body 16 and is electrically connected to the input circuit of the circuit pattern C.

The tip surface 20b is the surface located on the side opposite to the base end surface 20a. That is, the tip surface 20b and the base end surface 20a are in a back-to-back relationship with each other. A bus bar (not shown) or the like serving as an external conductor electrically connected with an external object can be fixed to the tip surface 20b. The tip surface 20b of this embodiment is provided with a screw hole T for bolt fastening. Since the screw hole T for bolt fastening is formed, an input bus bar (not shown) serving as an external conductor for current input can be fastened to the tip surface 20b using a bolt or the like (not shown).

The intermediate portion 20c extends in a direction moving away from the front surface 16a of the circuit board 15 to connect the base end surface 20a and the tip surface 20b. The intermediate portion 20c of this embodiment extends in a direction perpendicular to the front surface 16a of the circuit board 15 from the base end surface 20a and reaches the tip surface 20b. The current flowing from the tip surface 20b of the terminal block 20 reaches the base end surface 20a via the intermediate portion 20c and flows from the base end surface 20a to the input circuit of the circuit pattern C. Additionally, in this embodiment, the contour of the terminal block 20 in a cross-section perpendicular to the extension direction of the intermediate portion 20c is rectangular (specifically, substantially square).

The intermediate portion 20c is provided with a recessed portion 20d which extends in the direction along the circuit board 15. The recessed portion 20d includes a receiving surface 20e that faces the tip surface 20b. Further, the recessed portion 20d of this embodiment includes a facing surface 20g which is disposed to face the receiving surface 20e and a bottom surface 20f which connects the facing surface 20g and the receiving surface 20e. In this embodiment, one terminal block 20 is provided with two recessed portions 20d. These two recessed portions 20d are arranged at mutually symmetrical positions in one terminal block 20.

The power module 1 of this embodiment includes a first terminal block 21 and a second terminal block 22 as two terminal blocks 20 forming PN terminals. The first terminal block 21 and the second terminal block 22 are spaced apart from each other in the direction along the circuit board 15.

More specifically, the first terminal block 21 and the second terminal block 22 of this embodiment are arranged with a gap therebetween in the extension direction of one of four sides of the circuit board 15 formed in a rectangular shape in plan view and are arranged side by side along the one side.

From the viewpoint of inductance, it is preferable that the first terminal block 21 and second terminal block 22 be close to each other in the direction along the circuit board 15 as long as they do not come into contact with each other. That is, since the influence of the magnetic field generated by the current flowing through the first terminal block 21 and the second terminal block 22 can be increased as the gap between the first terminal block 21 and the second terminal block 22 in the direction along the circuit board 15 decreases, inductance can be reduced more effectively.

### (Power semiconductor element)

The power semiconductor element 12 is, for example, IGBT, MOSFET, FWD, or the like. In this embodiment, a case is exemplified in which six power semiconductor elements 12 are mounted on the circuit board 15. The power semiconductor element 12 includes an input terminal (not shown) and an output terminal (not shown). The input terminal (not shown) is electrically connected to the input circuit of the circuit pattern C formed in the front surface 16a of the circuit board body 16 of the base plate 10 via a bonding material or the like.

For example, one end of a lead frame (not shown) serving as a conducting wire is electrically connected to the output terminal (not shown). The other end of the lead frame is electrically connected to the output circuit of the circuit pattern C. That is, a current flows to the input terminal (not shown) via the circuit pattern C and a current converted by the power semiconductor element 12 is output from the output terminal (not shown). Further, a control signal generated by the control unit (not shown) is input to the power semiconductor element 12. The power semiconductor element 12 performs switching according to this control signal.

### (Cooler)

The cooler 40 is a device that cools the circuit board 15. The cooler 40 is provided on the second surface 10b of the base plate 10 via a bonding material or the like. The cooler 40 of this embodiment includes a cooler casing 41, a refrigerant inlet 42, and a refrigerant outlet 43.

The cooler casing 41 is bonded to the second surface 10b of the base plate 10 via a bonding material or the like. A flow path through which a refrigerant W flows is formed inside this cooler casing 41. The refrigerant inlet 42 guides the refrigerant W supplied from a refrigerant supply device (not shown) provided outside the power module 1 into the cooler casing 41. The refrigerant outlet 43 discharges the refrigerant W, flowing from the refrigerant inlet 42 and flowing through the cooler casing 41, to the outside. The refrigerant discharged from this refrigerant outlet 43 is returned to, for example, the refrigerant supply device.

That is, the heat of the power semiconductor element 12 is transferred to the refrigerant W via the circuit pattern C, the circuit board body 16, the base plate 10, the cooler casing 41, and the like and the power semiconductor element 12 is cooled.

For example, a bonding material such as solder, sintered material (powder of metal or ceramic), or adhesive can be used to bond the base plate 10 and the circuit board body 16, to bond the power semiconductor element 12 and the circuit pattern C, and to bond the base plate 10 and the cooler casing 41. Further, in this embodiment, for example, aluminum, iron, copper, ceramic, and the like can be adopted as the materials of the cooler casing 41, the refrigerant inlet 42, and the refrigerant outlet 43.

### (Output conductor)

The output conductor 30 is a conductor that outputs a current converted by the power semiconductor element 12. The output conductor 30 includes a base portion 31 and a connection portion 32.

The base portion 31 is a conductor serving as an output bus bar for current output extending toward the circuit board 15 provided on the first surface 10a from the outside of the base plate 10. The outer end portion of the base portion 31 is provided with a bolt fastening hole B. An output wiring for current output (not shown) is fastened to the outer end portion of the base portion 31 by a bolt.

The connection portion 32 is connected to the inner end portion of the base portion 31, extends from the inner end portion to reach the region of the circuit pattern C, and is electrically connected to the output circuit of the circuit pattern C formed in the front surface 16a of the board body.

### (Reinforcement portion)

FIG. 3 is a perspective view of the power module according to this embodiment and shows a state in which the reinforcement portion is provided.

As shown in FIG. 3, the reinforcement portion 50 is fixed to a part of the circuit board 15 and the base plate 10 and reinforces the terminal block 20. The reinforcement portion 50 is formed of a synthetic resin material. The reinforcement portion 50 covers the intermediate portion 20c of the terminal block 20 from the outside and surrounds the circuit board 15 from at least the outside. That is, the reinforcement portion 50 forms a casing that surrounds the circuit board 15 in the direction along the circuit board 15. The reinforcement portion 50 is fixed to the first surface 10a of the base plate 10 and the front surface 16a of a part of the circuit board body 16 by adhesive or the like.

In this embodiment, for example, an insulating material such as polyphenylene sulfide (PPS) as a synthetic resin material may be adopted in the reinforcement portion 50. In addition, insulating materials other than PPS may be adopted in the reinforcement portion 50.

The reinforcement portion 50 surrounds the circuit board 15 from the outside. A space is defined by the reinforcement portion 50 and the circuit board 15. Hereinafter, in this embodiment, the space defined by the reinforcement portion 50 and the circuit board 15 is referred to as a potting space P. A potting material is poured into the potting space P from the outside (potting), and at least the circuit pattern C provided on the front surface 16a of the circuit board body 16 and the power semiconductor element 12 are sealed.

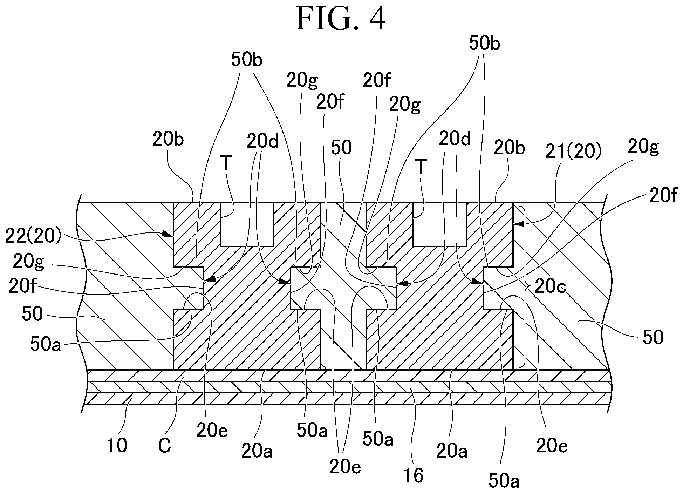

FIG. 4 is a cross-sectional view taken along a line IV-IV of FIG. 3.

As shown in FIG. 4, the reinforcement portion 50 of this embodiment is molded to enter the recessed portion 20d formed in the intermediate portion 20c of the terminal block 20. Accordingly, a first restriction surface 50a facing the receiving surface 20e is formed in the reinforcement portion 50 in the extension direction of the intermediate portion 20c of the terminal block 20. The first restriction surface 50a restricts the displacement of the terminal block 20 in a direction moving away from the front surface 16a of the circuit board 15.

Additionally, the reinforcement portion 50 of this embodiment is also provided with a second restriction surface 50b facing the facing surface 20g of the recessed portion 20d. Since the second restriction surface 50b facing the facing surface 20g is formed, the displacement of the terminal block 20 in the direction approaching the front surface 16a of the circuit board 15 is also restricted.

### (Method for manufacturing power module)

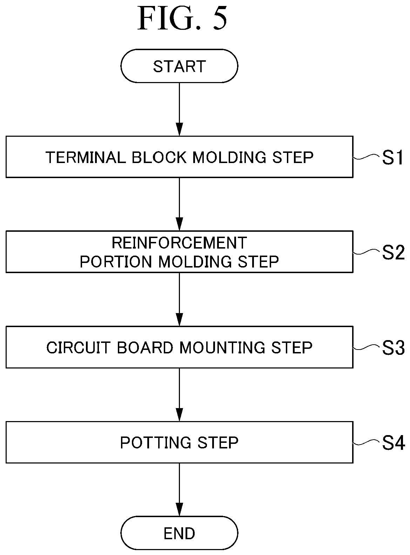

Next, a method for manufacturing the power module 1 of this embodiment will be described with reference to the flowchart shown in FIG. 5. The manufacturing method includes at least a terminal block molding step S1, a reinforcement portion molding step S2, a circuit board mounting step S3, and a potting step S4.

### (Terminal block molding step)

The terminal block molding step S1 is a step of molding the terminal block 20.

In this terminal block molding step S1, first, a substantially rectangular parallelepiped metal is prepared. In this embodiment, two substantially rectangular parallelepiped metals are prepared.

Next, the screw hole T is formed in one of the two longitudinally facing surfaces of the substantially rectangular parallelepiped metal. At this step, the surface provided with the screw hole T is the tip surface 20b and the surface not provided with the screw hole T is the base end surface 20a.

Next, the recessed portion 20d having a groove shape is formed between the base end surface 20a and the tip surface 20b of the substantially rectangular parallelepiped metal provided with the screw hole T, that is, the intermediate portion 20c.

Accordingly, there are provided two terminal blocks 20 that includes the base end surface 20a which is allowed to be fixed to the circuit board 15, the tip surface 20b which is allowed to fix the external conductor electrically connected to the external object, and the intermediate portion 20c which electrically connects the base end surface 20a and the tip surface 20b and the intermediate portion 20c is provided with the recessed portion 20d having the receiving surface 20e facing the tip surface 20b.

### (Reinforcement portion molding step)

In the reinforcement portion molding step S2, the two terminal blocks 20 formed in the terminal block molding step S1 are integrally molded to cover the reinforcement portion 50 formed of a synthetic resin.

In this reinforcement portion molding step S2, first, a synthetic resin material is prepared. For example, PPS is adopted as the synthetic resin used in the reinforcement portion molding step S2 of this embodiment. Additionally, synthetic resins other than PPS may be adopted in the reinforcement portion molding step S2.

Next, for example, the synthetic resin material is heated and melted and the synthetic resin is introduced into the recessed portions 20d of two terminal blocks 20 using a dedicated mold or the like and is supplied to cover the intermediate portion 20c of the terminal block 20 from the outside. Then, the synthetic resin is cured. Accordingly, the reinforcement portion 50 is integrally molded with two terminal blocks 20.

Additionally, in the reinforcement portion molding step S2, a molding method such as insert molding can be used, but molding methods other than insert molding may also be used.

### (Circuit board mounting step)

In the circuit board mounting step S3, two terminal blocks 20 integrally molded with the reinforcement portion 50 are mounted on the circuit board 15 fixed to the base plate 10 by the reinforcement portion molding step S2.

In this circuit board mounting step S3, first, the circuit board 15 fixed to the base plate 10 on which the terminal block 20 is mounted is prepared.

Next, a bonding material is applied to a predetermined mounting position of the circuit pattern C formed on the circuit board 15. As the bonding material used in the circuit board mounting step S3, for example, cream solder or the like can be exemplified, but materials other than cream solder may be adopted as the bonding material in the circuit board mounting step S3.

Next, the reinforcement portion 50 is mounted on the base plate 10 so that the base end surface 20a of the terminal block 20 contacts the bonding material applied to the mounting position of the circuit board 15. Then, these are placed inside a furnace heated to a predetermined temperature for a predetermined time. Accordingly, the bonding material between the base end surface 20a and the circuit pattern C is melted and the soldering is completed.

In this embodiment, for example, a reflow furnace or the like is adopted for the furnace used in the circuit board mounting step S3. Additionally, furnaces other than the reflow furnace may be adopted in the circuit board mounting step S3.

By the above-described procedure, the terminal block 20 molded with the reinforcement portion 50 is mounted on the circuit board 15.

### (Potting step)

In the potting step S4, a predetermined amount of a liquid potting material is poured into the potting space P and the potting material is cured.

In the potting step S4, first, a potting material is prepared. For example, silicone gel or epoxy resin can be used as the potting material. Additionally, synthetic resins other than silicone gel or epoxy resin may be used as the potting material.

On the other hand, in the potting step S4, the reinforcement portion 50 and the base plate 10 are adhered without any gaps using adhesive or the like. Accordingly, the reinforcement portion 50 is fixed to the base plate 10 and the gap between the reinforcement portion 50 and the base plate 10 is sealed. That is, when the potting material is poured into the potting space P, the potting material is prevented from leaking from the potting space P.

Next, a predetermined amount of the potting material is poured into the potting space P. The predetermined amount here means an amount that can cover at least the circuit pattern C formed on the front surface 16a of the circuit board body 16 and the power semiconductor element 12 mounted on the circuit pattern C without being exposed.

Through the above-described series of steps, the power module 1 is manufactured.

### (Operation and effect)

The power module 1 according to the first embodiment is the power module 1 for converting and outputting input power including: the circuit board 15 on which the power semiconductor element 12 is mounted; the base plate 10 to which the circuit board 15 is fixed; the terminal block 20 including the base end surface 20a which is fixed to the outer surface the surface of the circuit board 15 opposite to the base plate 10, the tip surface 20b to which the external conductor having the electrical connection with the external object is allowed to be fixed, and the intermediate portion 20c extending in a direction moving away from the front surface 16a of the circuit board 15 and electrically connecting the base end surface 20a and the tip surface 20b; and the reinforcement portion 50 which is fixed to at least one of the circuit board 15 and the base plate 10 and which is formed to reinforce the terminal block 20, wherein the intermediate portion 20c of the terminal block 20 includes the receiving surface 20e facing the side of the tip surface 20b and the reinforcement portion 50 includes the first restriction surface 50a which is formed to face the receiving surface 20e in the extension direction of the intermediate portion 20c and to restrict the displacement of the terminal block 20 in a direction moving away from the front surface 16a of the circuit board 15.

According to the above-described configuration, it is possible to restrict the displacement of the terminal block 20 in a direction moving away from the front surface 16a of the circuit board 15 by the first restriction surface 50a of the reinforcement portion 50. Therefore, for example, when the circuit board 15 is vibrated during the operation of the inverter or even when stress is applied to the terminal block 20 during the manufacturing of the power module 1, it is possible to suppress the terminal block 20 from coming off the circuit board 15. Further, since it is possible to mount the terminal block 20 on the circuit board 15, for example, the input terminal will not extend beyond the outer edge of the circuit board 15. Thus, it is possible to achieve miniaturization without reducing the reliability of the terminal.

Further, in the power module 1 according to the first embodiment, the reinforcement portion 50 is a casing surrounding the circuit board 15.

According to the above-described configuration, it is possible to reduce the number of parts compared to a case in which casings surrounding the reinforcement portion 50 and the circuit board 15 are individually provided. Further, since the circuit board 15 is surrounded by the reinforcement portion 50, it is possible to safely hold the power module 1.

Further, in the power module 1 according to the first embodiment, the intermediate portion 20c includes the recessed portion 20d extending in the direction along the circuit board 15 and the recessed portion 20d includes the receiving surface 20e.

According to the above-described configuration, it is possible to restrict not only the displacement of the terminal block 20 in a direction moving away from the front surface 16a of the circuit board 15 but also the displacement of the terminal block 20 in a direction moving close to the circuit board 15. Thus, it is possible to further reduce the load applied to the circuit board 15.

Further, the power module 1 according to the first embodiment further includes the cooler 40 which is installed to contact a surface of the base plate 10 opposite to the surface to which the circuit board 15 is fixed and configured to cool at least the circuit board 15.

According to the above-described configuration, it is also possible to cool the terminal block 20 fixed to the circuit board 15 using the cooler 40. Thus, it is also possible to cool the external conductor connected to the terminal block 20 via the terminal block 20.

Further, in the power module 1 according to the first embodiment, the potting space P is defined by the reinforcement portion 50 and the circuit board 15.

Thus, it is possible to easily seal the power semiconductor element 12 and the circuit pattern C provided in the front surface 16a of the circuit board body 16 by pouring the potting material into the potting space P defined by the reinforcement portion 50 and the circuit board 15.

Further, the method for manufacturing the power module 1 according to the first embodiment includes: the terminal block molding step S1 of molding the terminal block 20 that includes the base end surface 20a which is allowed to be fixed to the circuit board 15, the tip surface 20b to which the external conductor electrically connected to the outside is allowed to be fixed, and the intermediate portion 20c electrically connecting the base end surface 20a and the tip surface 20b, and with the intermediate portion 20c includes the recessed portion 20d having the receiving surface 20e facing the side of the tip surface 20b; and the reinforcement portion molding step S2 of supplying a synthetic resin material to enter the recessed portion 20d, supplying the synthetic resin material to cover the intermediate portion 20c of the terminal block 20, and curing the synthetic resin material to mold the reinforcement portion 50.

According to the above-described configuration, the reinforcement portion 50 that reinforces the terminal block 20 can be easily molded.

### Second Embodiment

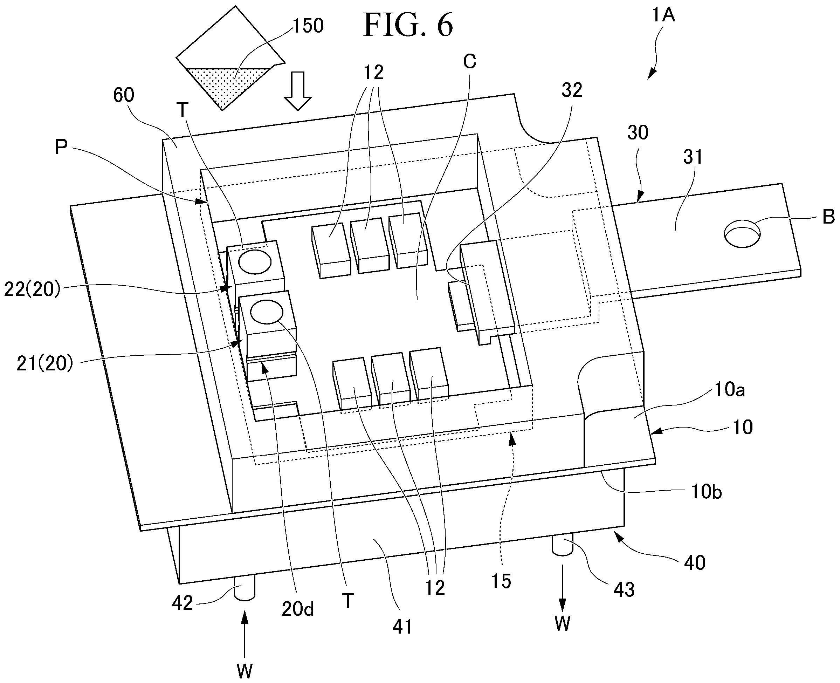

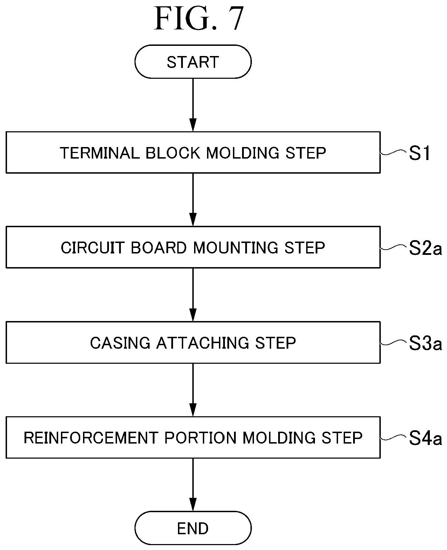

Hereinafter, a power module and a method for manufacturing the power module according to a second embodiment of the present disclosure will be described with reference to FIGS. 6 and 7. The reinforcement portion described in the second embodiment is different from the reinforcement portion 50 of the power module 1 of the first embodiment only in a part of the configuration thereof. Components similar to those in the first embodiment are indicated by the same reference numerals and detailed descriptions are omitted.

FIG. 6 is a perspective view of the power module of the second embodiment.

As shown in FIG. 6, a reinforcement portion 150 of a power module 1A of this embodiment is formed of a potting material and the power module 1A further includes an insulating casing 60.

### (Insulating casing)

The insulating casing 60 surrounds the circuit board 15 from the outside. The potting space P is defined by the insulating casing 60 and the circuit board 15. The terminal block 20, the power semiconductor element 12, and the connection portion 32 of the output conductor 30 are arranged in the potting space P of this embodiment. The insulating casing 60 is adhered to the first surface 10a of the base plate 10 by adhesive or the like. The insulating casing 60 can be formed of, for example, an insulating material such as PPS which is a synthetic resin. Additionally, the insulating casing 60 may be formed of insulating materials other than PPS.

### (Reinforcement portion)

The reinforcement portion 150 of this embodiment is formed of a potting material. The reinforcement portion 150 is formed in the potting space P.

More specifically, the reinforcement portion 150 is formed to fill the potting space P from the front surface 16a of the circuit board body 16 to at least a position farther from the front surface 16a of the circuit board 15 than the receiving surface 20e of the recessed portion 20d of the terminal block 20.

Further, the reinforcement portion 150 is formed to enter the recessed portion 20d formed in the intermediate portion 20c of the terminal block 20 similarly to the reinforcement portion 150 of the first embodiment. In other words, the reinforcement portion 150 includes the first restriction surface 50a which faces the receiving surface 20e in the extension direction of the intermediate portion 20c of the terminal block 20. Additionally, the reinforcement portion 150 can adopt, for example, an epoxy resin or the like, but may adopt materials other than the epoxy resin.

### (Method for manufacturing power module)

Next, a method for manufacturing the power module 1A of this embodiment will e described with reference to the flowchart shown in FIG. 7. The manufacturing method includes at least the terminal block molding step S1, a circuit board mounting step S2a, a casing attaching step S3a, and a reinforcement portion molding step S4a. Additionally, since the terminal block molding step S1 is the same as that in the first embodiment, description thereof will be omitted.

### (Circuit board mounting step)

The circuit board mounting step S2a is performed after the terminal block molding step S1.

In the circuit board mounting step S2a, the terminal block 20 is mounted on the circuit board 15 fixed to the base plate 10.

In this circuit board mounting step S2a, first, the circuit board 15 fixed to the base plate 10 which is a mounting position of the terminal block 20 is prepared.

Next, a bonding material is applied to a predetermined mounting position of the circuit pattern C formed on the circuit board 15. Then, the terminal block 20 is mounted on the circuit board 15 so that the base end surface 20a of the terminal block 20 contacts the bonding material applied to the mounting position of the circuit board 15. Then, these are placed inside a furnace heated to a predetermined temperature for a predetermined time. Accordingly, the bonding material between the base end surface 20a and the circuit pattern C is melted and the soldering is completed, so that the terminal block 20 is mounted on the circuit board 15.

### (Casing attaching step)

In the casing attaching step S3a, the insulating casing 60 is attached to the circuit board 15 mounted with the terminal block 20.

In this casing attaching step S3a, first, the insulating casing 60 is prepared. The insulating casing 60 can be molded by injection molding using a dedicated mold or the like. Additionally, the method for manufacturing the insulating casing 60 may be molding methods other than injection molding.

Then, the insulating casing 60 is adhered to the base plate 10 via adhesive or the like to cover the circuit board 15 mounted with the terminal block 20 from the outside.

By the above-described procedure, the insulating casing 60 is attached to the base plate 10.

### (Reinforcement portion molding step)

In the reinforcement portion molding step S4a, a predetermined amount of a liquid potting material is poured into the potting space P and the potting material is cured to mold the reinforcement portion 150.

In this reinforcement portion molding step S4a, first, a potting material is prepared as a material for molding the reinforcement portion 150. As the potting material used in the reinforcement portion molding step S4a, for example, an epoxy resin or the like can be adopted. In addition, synthetic resins other than the epoxy resin may be adopted as the potting material.

In the reinforcement portion molding step S4a, next, a predetermined amount of the potting material is poured into the potting space P. At that time, the potting material is poured to at least a position entering the recessed portion 20d formed in the intermediate portion 20c of the terminal block 20. Then, the poured potting material is cured. This cured potting material becomes the reinforcement portion 150.

Through the above-described steps, the power module 1A is manufactured.

### (Operation and effect)

In the power module 1A according to the second embodiment, the reinforcement portion 150 is formed of the potting material.

According to the above-described configuration, it is possible to form the reinforcement portion 150 that enters the recessed portion 20d of the terminal block 20 by a simple method called potting. Thus, the number of steps in manufacturing the power module 1A can be reduced. Further, the circuit board 15, the terminal block 20, the power semiconductor element 12, and the insulating casing 60 are united by the reinforcement portion 150 by potting. Accordingly, it is possible to improve the strength of the power module 1A against vibrations generated on the circuit board 15 during the operation of the inverter.

### Modified Example of Embodiment

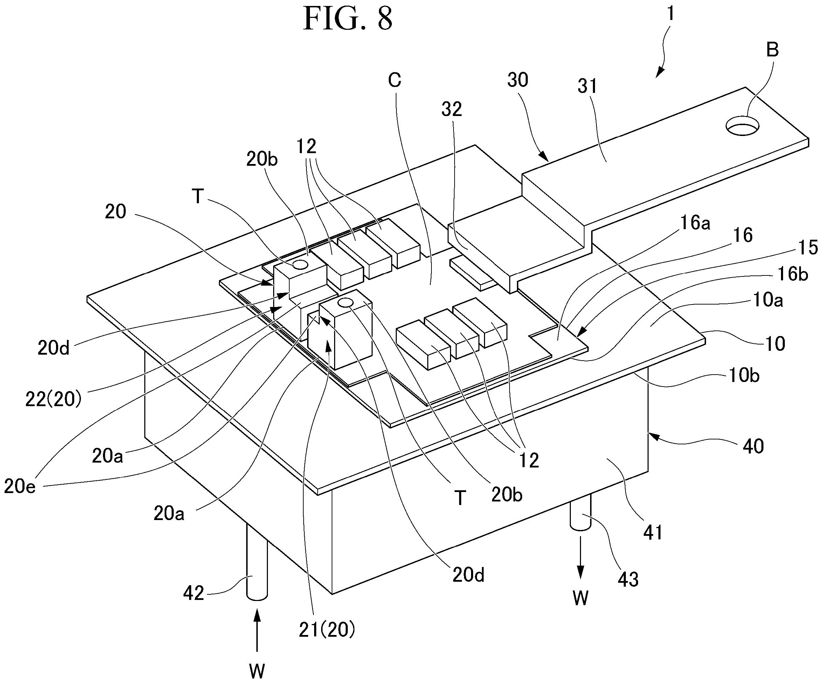

FIG. 8 shows a modified example of the terminal block of the power module according to the embodiment of the present disclosure. FIG. 8 shows a state in which the reinforcement portion is removed.

The power modules 1 and 1A of the above-described embodiments may include the first terminal block 21 and the second terminal block 22 without the groove-shaped recessed portion 20d shown in FIG. 8 as the terminal block 20.

The first terminal block 21 and the second terminal block 22 in this modified example are spaced apart from each other in the direction along the circuit board 15 similarly to the first and second embodiments. In this modified example, the receiving surface 20e of the recessed portion 20d provided in the intermediate portion 20c of the first terminal block 21 is provided closer to the second terminal block 22 than the tip surface 20b of the first terminal block 21. Further, the receiving surface 20e of the recessed portion 20d provided in the intermediate portion 20c of the second terminal block 22 is provided closer to the first terminal block 21 than the tip surface 20b of the second terminal block 22.

According to the configuration of the modified example, the separation distance between the tip surfaces 20b of the first terminal block 21 and the second terminal block 22 can be made larger than the separation distance between the receiving surfaces 20e. Therefore, it is possible to reduce inductance while ensuring an insulating distance between the bolt fastening holes B that are connected to the input bus bar. Further, since the first terminal block 21 and the second terminal block 22 include the receiving surface 20e, the operation and effect described in the above-described embodiments can be realized.

### Other Embodiments

Although the embodiments and modified examples of the present disclosure have been described above in detail with reference to the drawings, the specific configuration is not limited to the configuration of each embodiment and addition, omission, replacement, and other modifications of the configuration can be made without departing from the gist of the present disclosure. Further, the present disclosure is not limited to the embodiments.

In the above-described embodiments, the tip surface 20b of the terminal block 20 is formed to have the screw hole T for bolt fastening, but the configuration is not limited to the configuration in which the screw hole T is cut. For example, a configuration in which a male screw portion protruding from the tip surface 20b is formed may be used.

Further, in the above-described embodiments, the intermediate portions 20c of two terminal blocks 20 respectively include two recessed portions 20d, but the number of the recessed portions 20d is not limited to two. The number of the recessed portions 20d may be one or three or more.

Further, in the above-described embodiments, the recessed portion 20d provided in the intermediate portion 20c extends in the direction along the circuit board 15, but the present disclosure is not limited thereto.

Further, in the above-described embodiments, the power modules 1 and 1A are used in the inverters, but the present disclosure is not limited to the inverters. The power modules 1 and 1A may constitute a part of a converter that receives an alternating current and outputs a direct current or a booster circuit or the like of a regulator that changes the magnitude of the voltage of the direct current.

Further, the order of the steps in the second embodiment is not limited to the above description and the circuit board mounting step S2a and the case attaching step S3a may be in a different order.

### Appendix

The power module described in the embodiment is understood, for example, as below.
(1) The power modules 1 and 1A according to a first aspect are the power modules 1 and 1A for converting and outputting input power including: the circuit board 15 on which the power semiconductor element 12 is mounted; the base plate 10 to which the circuit board 15 is fixed; the terminal block 20 including the base end surface 20a which is fixed to the outer surface of the circuit board 15 opposite to the base plate 10, the tip surface 20b to which the external conductor having the electrical connection with an external object is allowed to be fixed, and the intermediate portion 20c extending in a direction moving away from the front surface 16a of the circuit board 15 and electrically connects the base end surface 20a and the tip surface 20b; and the reinforcement portion 50 which is fixed to at least one of the circuit board 15 and the base plate 10 and which is formed to reinforce the terminal block 20, wherein the intermediate portion 20c of the terminal block 20 includes the receiving surface 20e which faces the side of the tip surface 20b, and wherein the reinforcement portion 50 includes the first restriction surface 50a which is formed to face the receiving surface 20e in the extending direction of the intermediate portion 20c to restrict the displacement of the terminal block 20 in a direction moving away from the front surface 16a of the circuit board 15.

According to the above-described configuration, it is possible to restrict the displacement of the terminal block 20 in a direction moving away from the front surface 16a of the circuit board 15 by the first restriction surface 50a of the reinforcement portion 50. Therefore, for example, when the circuit board 15 is vibrated during the operation of the inverter or even when stress is applied to the terminal block 20 during the manufacturing of the power module 1, it is possible to suppress the terminal block 20 from coming off the circuit board 15. Further, since it is possible to mount the terminal block 20 on the circuit board 15, for example, the input terminal will not extend beyond the outer edge of the circuit board 15. Thus, it is possible to achieve miniaturization without reducing the reliability of the terminal.

(2) The power module 1 according to a second aspect is the power module 1 of (1), wherein the reinforcement portion 50 may be a casing surrounding the circuit board 15.

According to the above-described configuration, it is possible to reduce the number of parts compared to a case in which casings surrounding the reinforcement portion 50 and the circuit board 15 are individually provided. Further, since the circuit board 15 is surrounded by the reinforcement portion 50, it is possible to safely hold the power module 1.

(3) The power module 1A according to a third aspect is the power module 1A of (1), wherein the reinforcement portion 150 may be formed of a potting material.

According to the above-described configuration, it is possible to form the reinforcement portion 150 that enters the recessed portion 20d of the terminal block 20 by a simple method called potting. Thus, the number of steps in manufacturing the power module 1A can be reduced. Further, the circuit board 15, the terminal block 20, the power semiconductor element 12, and the insulating casing 60 are united by the reinforcement portion 150 by potting. Accordingly, it is possible to improve the strength of the power module 1A against vibrations generated on the circuit board 15 during the operation of the inverter.

(4) The power modules 1 and 1A according to a fourth aspect are the power modules 1 and 1A of any one of (1) to (3), wherein the intermediate portion 20c may include the recessed portion 20d extending in the direction along the circuit board 15 and the recessed portion 20d may include the receiving surface 20e.

According to the above-described configuration, it is possible to restrict not only the displacement of the terminal block 20 in a direction moving away from the front surface 16a of the circuit board 15 but also the displacement of the terminal block 20 in a direction moving close to the circuit board 15. Thus, it is possible to further reduce the load applied to the circuit board 15.

(5) The power modules 1 and 1A according to a fifth aspect are the power modules 1 and 1A of any one of (1) to (3), wherein the power module may include the first and second terminal blocks 21 and forming PN terminals as the terminal block 20, wherein the first and second terminal blocks 21 and 22 may be spaced apart from each other in the direction along the circuit board 15, wherein the receiving surface 20e of the first terminal block 21 may be formed closer to the second terminal block 22 than the tip surface 20b of the first terminal block 21, and wherein the receiving surface 20e of the second terminal block 22 may be formed closer to the first terminal block 21 than the tip surface 20b of the second terminal block 22.

According to the above-described configuration, the separation distance between the tip surfaces 20b of the first terminal block 21 and the second terminal block 22 can be made larger than the separation distance between the receiving surfaces 20e. Therefore, it is possible to reduce inductance while ensuring an insulating distance between the bolt fastening holes B that are connected to the input bus bar. Further, since the first terminal block 21 and the second terminal block 22 include the receiving surface 20e, the operation and effect described in the above-described embodiments can be realized.

(6) The power modules 1 and 1A according to a sixth aspect are the power modules 1 and 1A of any one of (1) to (5) may further include: the cooler 40 which is installed to contact the surface of the base plate 10 opposite to the surface to which the circuit board 15 is fixed and configured to cool at least the circuit board 15.

According to the above-described configuration, it is also possible to cool the terminal block 20 fixed to the circuit board 15 using the cooler 40. Thus, it is also possible to cool the external conductor connected to the terminal block 20 via the terminal block 20.

(7) A method for manufacturing the power modules 1 and 1A according to a seventh aspect includes: the terminal block molding steps S1 and S1a of molding the terminal block 20 that includes the base end surface 20a which is allowed to be fixed to the circuit board 15, the tip surface 20b to which the external conductor electrically connected to the outside is allowed to be fixed, and the intermediate portion 20c electrically connecting the base end surface 20a and the tip surface 20b, and the intermediate portion 20c includes the recessed portion 20d having the receiving surface 20e facing the side of the tip surface 20b; and the reinforcement portion molding steps S2 and S4a of molding the reinforcement portion 50 by supplying liquid synthetic resin into the recessed portion 20d to cover the intermediate portion 20c of the terminal block 20, and curing the synthetic resin in the recessed portion 20d.

According to the above-described configuration, the reinforcement portion 50 that reinforces the terminal block 20 can be easily molded.

### Industrial Applicability

According to the present disclosure, it is possible to provide a power module that can be miniaturized without reducing the reliability of terminals and a method for manufacturing the power module.

### Reference Signs List

1, 1A Power module
10 Base plate
10a First surface
10b Second surface
12 Power semiconductor element
15 Circuit board
16 Circuit board body
16a Front surface
16b Rear surface
20 Terminal block
20a Base end surface
20b Tip surface
20c Intermediate portion
20d Recessed portion
20e Receiving surface
20f Bottom surface
20g Facing surface
21 First terminal block
22 Second terminal block
30 Output conductor
31 Base portion
32 Connection portion
40 Cooler
41 Cooler casing
42 Refrigerant inlet
43 Refrigerant outlet
50, 150 Reinforcement portion
50a First restriction surface
50b Second restriction surface
60 Insulating casing
B Bolt fastening hole
C Circuit pattern
P Potting space
S1 Terminal block molding step
S2, S4a Reinforcement portion molding step
S3, S2a Circuit board mounting step
S3a casing attaching step
S4 Potting step
T Screw hole
W Refrigerant

## Claims

1. A power module for converting and outputting input power comprising:
a circuit board on which a power semiconductor element is mounted;
a base plate to which the circuit board is fixed;
a terminal block including a base end surface which is fixed to an outer surface of the circuit board opposite to the base plate, a tip surface to which an external conductor having an electrical connection with an external object is allowed to be fixed, and an intermediate portion extending in a direction moving away from a front surface of the circuit board and electrically connecting the base end surface and the tip surface; and
a reinforcement portion which is fixed to at least one of the circuit board and the base plate and which is formed to reinforce the terminal block,
wherein the intermediate portion of the terminal block includes a receiving surface facing the tip surface side, and
wherein the reinforcement portion includes a restriction surface which is formed to face the receiving surface in an extending direction of the intermediate portion to restrict displacement of the terminal block in a direction moving away from the front surface of the circuit board.

2. The power module according to claim 1,
wherein the reinforcement portion is a casing surrounding the circuit board.

3. The power module according to claim 1,
wherein the reinforcement portion is formed of a potting material.

4. The power module according to any one of claims 1 to 3,
wherein the intermediate portion includes a recessed portion extending in a direction along the circuit board, and
wherein the recessed portion includes the receiving surface.

5. The power module according to any one of claims 1 to 3,
wherein the power module includes first and second terminal blocks forming PN terminals as the terminal block,
wherein the first and second terminal blocks are spaced apart from each other in a direction along the circuit board,
wherein the receiving surface of the first terminal block is formed closer to the second terminal block than the tip surface of the first terminal block, and
wherein the receiving surface of the second terminal block is formed closer to the first terminal block than the tip surface of the second terminal block.

6. The power module according to any one of claims 1 to 5, further comprising:
a cooler which is installed to contact a surface of the base plate opposite to a surface to which the circuit board is fixed and configured to cool at least the circuit board.

7. A method for manufacturing a power module comprising:
a terminal block molding step of molding a terminal block including a base end surface which is allowed to be fixed to a circuit board, a tip surface to which an external conductor electrically connected to an outside is allowed to be fixed, and an intermediate portion electrically connecting the base end surface and the tip surface, and the intermediate portion includes a recessed portion having a receiving surface facing the tip surface side; and
a reinforcement portion molding step of molding a reinforcement portion by supplying liquid synthetic resin into the recessed portion to cover the intermediate portion of the terminal block, and curing the synthetic resin in the recessed portion.
